(19) **Europäisches Patentamt / European Patent Office / Office européen des brevets**

(11) **EP 2 227 701 B1**

(12) **FASCICULE DE BREVET EUROPEEN**

(45) Date de publication et mention de la délivrance du brevet:
**22.01.2020 Bulletin 2020/04**

(51) Int Cl.:
***G01R 31/11*** *(2006.01)*    ***H04B 3/462*** *(2015.01)*

(21) Numéro de dépôt: **08869965.7**

(22) Date de dépôt: **19.12.2008**

(86) Numéro de dépôt international:
**PCT/EP2008/068008**

(87) Numéro de publication internationale:
**WO 2009/087045 (16.07.2009 Gazette 2009/29)**

(54) **PROCEDE DE DETECTION ET DE LOCALISATION DE DEFAUTS PAR REFLECTOMETRIE DANS UN RESEAU ELECTRIQUE CABLE ET DISPOSITIF CORRESPONDANT**

VERFAHREN ZUR ERKENNUNG UND LOKALISIERUNG VON SCHÄDEN IN EINEM ELEKTRISCHEN KABELNETZWERK DURCH REFLEKTROMETRIE UND ENTSPRECHENDE VORRICHTUNG

METHOD FOR DETECTING AND LOCATING DEFECTS BY REFLECTOMETRY IN A WIRED ELECTRIC NETWORK AND CORRESPONDING DEVICE

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **03.01.2008 FR 0850013**

(43) Date de publication de la demande:
**15.09.2010 Bulletin 2010/37**

(73) Titulaire: **Commissariat à l'Énergie Atomique et aux Énergies Alternatives**
**75015 Paris (FR)**

(72) Inventeurs:
• **GUILHEMSANG, Julien**
  **F-94000 Créteil (FR)**

• **AUZANNEAU, Fabrice**
  **F-91300 Massy (FR)**
• **BONHOMME, Yannick**
  **F-91530 Le Val Saint Germain (FR)**

(74) Mandataire: **Ilgart, Jean-Christophe et al**
**BREVALEX**
**95, rue d'Amsterdam**
**75378 Paris Cedex 8 (FR)**

(56) Documents cités:
**EP-A- 0 652 442    EP-A- 0 768 537**
**US-A- 5 521 512    US-A1- 2005 052 190**

**Description**

DOMAINE TECHNIQUE

L'invention se situe dans le domaine de détection de défauts dans des câbles électriques et concerne plus spécifiquement un procédé de détection et de localisation de défauts par réflectométrie dans un réseau électrique câblé comportant les étapes suivantes :

- injecter un signal de test dans un câble dudit réseau,
- récupérer un signal réfléchi sur ledit câble,
- échantillonner ledit signal réfléchi à une fréquence Fe=1/Te.

L'invention concerne également un dispositif adapté pour mettre en œuvre le procédé selon l'invention.
Le procédé et le dispositif selon l'invention sont particulièrement adaptés pour détecter des défauts en temps réel dans un réseau câblé d'un système embarqué.

ÉTAT DE LA TECHNIQUE ANTÉRIEURE

L'intégration croissante de dispositifs électroniques complexes pour effectuer des opérations de contrôle, de surveillance et de communication intelligentes en temps réel, notamment dans des systèmes embarqués, a conduit à une forte augmentation de l'utilisation de réseaux électriques câblés, pour l'alimentation et le transfert de données.
Cette évolution a entraîné une forte augmentation de la probabilité d'avoir un réseau électrique défectueux en raison des contraintes externes (mécaniques, température, humidité...) subies par les câbles d'alimentation et de transfert d'information et les connecteurs électriques. Ces contraintes sont souvent la cause d'une détérioration prématurée du réseau électrique.
Ainsi, un réseau électrique peut être mis en panne à cause d'anomalies provenant d'un connecteur ou d'une liaison électrique en mauvais état. De nombreuses problématiques apparaissent actuellement faisant référence à des défaillances liées aux câbles et peuvent parfois être lourdes de conséquences (incendie, crash aérien, panne d'un véhicule.).
Aussi, la capacité de pouvoir surveiller l'état des liaisons électriques est un atout supplémentaire pour augmenter la fiabilité des réseaux électriques et particulièrement les réseaux électriques embarqués.
Dans ce contexte, l'invention a pour but de proposer un procédé et un dispositif performant, à faible coût, utilisant la réflectométrie pour surveiller l'état des câbles d'un réseau électrique en vue de la détection, la localisation et la caractérisation d'éventuels défauts avec une grande précision.
La réflectométrie est une méthode basée sur le principe du radar qui consiste à injecter une onde dans un milieu et analyser l'onde réfléchie en utilisant les phénomènes de propagation des ondes dans les milieux physiques.
Pour utiliser la réflectométrie dans l'analyse de l'état d'un câble électrique, il est nécessaire d'injecter dans ce câble des signaux dont la longueur d'onde est petite ou équivalente à la longueur du câble, ceci implique donc l'utilisation de signaux de haute fréquence ou large bande. La réflectométrie occupe essentiellement deux domaines d'analyse : la réflectométrie dans le domaine temporel ou TDR (pour Time Domain Reflectometry) et la réflectométrie dans le domaine fréquentiel ou FDR (pour Frequency Domain Reflectometry).
Un problème technique provient du fait que la précision de la mesure de réflectométrie dépend de deux variables : la vitesse d'échantillonnage et la durée du signal injecté.
Pour améliorer la précision de mesure, il convient d'augmenter la vitesse d'échantillonnage du système de mesure et de diminuer la durée du signal injecté.
Pour un dispositif de diagnostic embarqué, l'augmentation de la vitesse d'échantillonnage peut être difficile et peut entraîner de lourdes contraintes (augmentation du coût et de la complexité, de la consommation, de la température, etc.). En effet la vitesse de fonctionnement des dispositifs d'échantillonnage est de l'ordre de la centaine de mégahertz. Or pour un câble coaxial, la précision du diagnostic évolue comme suit :

1m de précision à 100 MHz,
10cm de précision à 1 GHz,
1cm de précision à 10 GHz,
etc.

Or, une précision de 1m n'est pas suffisante pour une application embarquée, par exemple dans le cas du diagnostic d'un câblage automobile. De plus une précision centimétrique entraîne de lourdes contraintes, difficiles à satisfaire dans le cas d'un réseau électrique embarqué.

En outre, l'augmentation de la vitesse d'échantillonnage se heurte, d'une part, à un problème d'ordre économique dû au coût des composants permettant de numériser les signaux à hautes fréquences, à la complexité de mise en œuvre de ces composants, et d'autre part, à un problème d'ordre technique, dû au fait que les câbles à surveiller possèdent en général une bande passante beaucoup plus basse que celle utilisée par le signal de diagnostic injecté.

En effet, un câble de transport de signaux de haute tension est prévu pour transporter de l'énergie et n'est pas prévu à l'origine pour propager des signaux haute fréquence. Cela se traduit par une atténuation du signal de diagnostic, qui est d'autant plus grande qu'on diminue la durée du signal de diagnostic.

Par ailleurs, il est difficile de détecter un défaut si le signal de diagnostic est trop atténué même si le dispositif de diagnostic présente une vitesse d'échantillonnage correcte.

Un premier but de l'invention est d'améliorer la précision de la technique de détection et de localisation de défauts par réflectométrie sur un câble d'un réseau électrique.

Un autre but de l'invention consiste à utiliser la technique de la réflectométrie pour la détection et la localisation de défauts dans un réseau électrique embarqué au moyen d'un dispositif comportant des convertisseurs analogiques-numériques courants, de faibles coût, fonctionnant à des fréquences de quelques dizaines Mégahertz à quelques centaines de Mégahertz, facilement contrôlables avec un FPGA (pour Field Programmable Gate Array).

EXPOSÉ DE L'INVENTION

Ces buts sont atteints au moyen d'un procédé de détection et de localisation de défauts par réflectométrie dans un réseau électrique câblé tel que dans les revendications indépendantes 1 et 2.

Le procédé comporte en outre une étape au cours de laquelle les échantillons récupérés sont comparés à un seuil adaptatif défini, pour chaque diagnostic, en fonction du signal de test injecté dans le câble testé.

L'invention suppose que les signaux acquis sont stationnaires, ce qui est le cas général pour l'application envisagée.

Dans un premier mode de mise en œuvre du procédé, à chaque phase d'acquisition, l'injection d'un signal de test dans un câble dudit réseau est désynchronisée par rapport à l'instant de début de ladite phase d'acquisition d'une durée incrémentée d'une valeur $\delta$, et le premier échantillon du signal réfléchi est récupéré de manière synchrone avec le début de ladite phase d'acquisition, les échantillons suivants dudit signal réfléchi étant récupérés avec un retard constant, multiple de la période d'échantillonnage Te, par rapport audit premier échantillon.

Dans un deuxième mode de mise en œuvre du procédé, à chaque phase d'acquisition, l'injection d'un signal de test dans un câble dudit réseau est synchronisée avec l'instant de début de ladite phase d'acquisition, et le premier échantillon du signal réfléchi est récupéré de manière désynchronisée par rapport au début de ladite phase d'acquisition d'une durée incrémentée d'une valeur $\delta$, les échantillons suivants dudit signal réfléchi étant récupérés avec un retard constant, multiple de la période d'échantillonnage Te, par rapport audit premier échantillon.

Dans le cas où $\delta$ est égal à Te/N, l'invention permet de simuler un échantillonnage à une fréquence N/Te et donc d'améliorer la précision de localisation d'un facteur N.

Dans un troisième mode de mise en œuvre du procédé, à chaque phase d'acquisition, l'injection d'un signal de test dans un câble dudit réseau est désynchronisée par rapport à l'instant de début de ladite phase d'acquisition d'une durée incrémentée d'une valeur $\delta1$, et le premier échantillon du signal réfléchi est récupéré de manière désynchronisée par rapport au début de ladite phase d'acquisition d'une durée incrémentée d'une valeur $\delta2$, les échantillons suivants dudit signal réfléchi étant récupérés avec un retard constant, multiple de la période d'échantillonnage Te, par rapport audit premier échantillon.

Préférentiellement, les valeurs des durées $\delta$, $\delta1$ et $\delta2$ sont indépendantes de la période d'échantillonnage Te.

Le procédé comporte en outre une étape préalable à l'analyse des échantillons récupérés consistant à reconstituer un signal réfléchi à partir desdits M échantillons et à détecter et localiser un défaut dans le réseau électrique câblé à partir de l'analyse du signal ainsi reconstitué.

La détection et la localisation d'un défaut dans le réseau électrique câblé sont effectuées par analyse en temps réel de chaque échantillon récupéré et par un traitement des résultats des analyses successives.

Selon une caractéristique supplémentaire du procédé, le nombre N est choisi en fonction de la précision souhaitée de détection et de localisation du défaut sur un câble électrique.

Dans un mode préféré de mise en œuvre du procédé, le signal test est un signal rectangulaire.

Dans ce mode de réalisation, le procédé comporte en outre une étape consistant à contrôler la durée dudit signal rectangulaire.

Alternativement, ledit signal test est composé d'une suite de signaux rectangulaires.

Lorsqu'un défaut est détecté sur un câble du réseau, la localisation du défaut sur ledit câble est déterminée en fonction de la durée séparant l'instant d'émission du signal test injecté dans ledit câble de l'instant d'arrivée du signal réfléchi correspondant au défaut sur ledit câble.

Le procédé selon l'invention est mis en œuvre au moyen d'un dispositif selon la revendication indépendante 9.

Ledit dispositif comporte en outre des moyens pour comparer lesdits échantillons récupérés à un seuil adaptatif défini, pour chaque diagnostic, en fonction du signal de test injecté et du câble testé.

Le module de contrôle comporte en outre un module de synchronisation pour générer une horloge d'émission et une horloge de réception, la fréquence de ladite horloge d'émission étant désynchronisée par rapport à la fréquence d'échantillonnage du signal réfléchi.

Ledit module de synchronisation est un circuit PLL ou un circuit DLL.

Un circuit PLL est une boucle à verrouillage de phase permettant d'asservir la phase instantanée de sortie sur la phase instantanée d'entrée, et, également une fréquence de sortie sur un multiple de la fréquence d'entrée. Un circuit DLL (pour Delay Locked Loop) est un circuit similaire à un circuit PLL dans lequel il n'y a pas d'oscillateur. Ce circuit peut être utilisé pour changer la phase d'un signal d'horloge.

L'horloge d'émission est configurée de sorte que chaque émission est désynchronisée de l'émission qui la précède d'une durée $\delta$.

Dans une première variante, l'horloge d'émission est configurée de sorte que les instants d'injection successifs d'un signal de test dans un câble dudit réseau soient désynchronisés d'une durée incrémentée de $\delta$ par rapport à l'horloge de réception, et l'horloge de réception détermine l'instant auquel le premier échantillon du signal réfléchi est récupéré, les échantillons suivants dudit signal réfléchi étant récupérés avec un retard constant, multiple de la période d'échantillonnage Te, par rapport audit premier échantillon.

Dans une deuxième variante, l'horloge d'émission détermine les instants auxquels les injections successives d'un signal de test dans un câble dudit réseau sont faites, et l'horloge de réception est configurée de sorte que pour chaque signal injecté, le premier échantillon du signal réfléchi soit récupéré de manière désynchronisée d'une durée incrémentée de $\delta$ par rapport à l'horloge d'émission, les échantillons suivants du signal réfléchi étant récupérés avec un retard constant, multiple de la période d'échantillonnage Te, par rapport au premier échantillon.

Dans une troisième variante, le dispositif comporte une horloge globale qui rythme le fonctionnement du système, et l'horloge d'émission est configurée de sorte que les injections successives d'un signal de test dans un câble dudit réseau soient désynchronisées par rapport à ladite horloge globale d'une durée incrémentée de $\delta1$, et l'horloge de réception est configurée de sorte que pour chaque signal injecté, le premier échantillon du signal réfléchi soit récupéré de manière désynchronisée d'une durée incrémentée de $\delta2$ par rapport à l'horloge globale, les échantillons suivants du signal réfléchi étant récupérés avec un retard constant, multiple de la période d'échantillonnage Te, par rapport au premier échantillon.

Dans une quatrième variante l'horloge d'émission est configurée de sorte que les injections successives d'un signal de test dans un câble dudit réseau soient désynchronisées par rapport à la période d'échantillonnage Te d'une durée $\delta1$, et l'horloge de réception est configurée de sorte que pour chaque signal injecté, le premier échantillon du signal réfléchi soit récupéré de manière désynchronisée d'une durée $\delta2$ par rapport à la durée $\delta1$, les échantillons suivants du signal réfléchi étant récupérés avec un retard constant, multiple de Te, par rapport au premier échantillon.

Préférentiellement, ledit module de synchronisation est constitué par un circuit PLL ou DLL.

BRÈVE DESCRIPTION DES DESSINS

D'autres caractéristiques et avantages de l'invention ressortiront de la description qui va suivre, prise à titre d'exemple non limitatif, en référence aux figures annexées dans lesquelles :

- la figure 1 représente un schéma de principe comportant un réseau câblé et un dispositif mettant en œuvre le procédé selon l'invention,
- la figure 2 représente un dispositif destiné à mettre en œuvre le procédé selon l'invention selon un premier mode de réalisation,
- la figure 3 représente schématiquement un module de contrôle intégré au dispositif destiné à mettre en œuvre le procédé selon l'invention,
- la figure 4 représente schématiquement un module de synchronisation intégré au module de contrôle de la figure 3.
- la figure 5 illustre le principe de sur-échantillonnage selon le procédé de l'invention,
- la figure 6 représente un organigramme illustrant un premier mode de mise en œuvre du procédé selon l'invention,
- la figure 7 représente un organigramme illustrant un deuxième mode de mise en œuvre du procédé selon l'invention.

EXPOSÉ DÉTAILLÉ DE MODES DE RÉALISATION PARTICULIERS

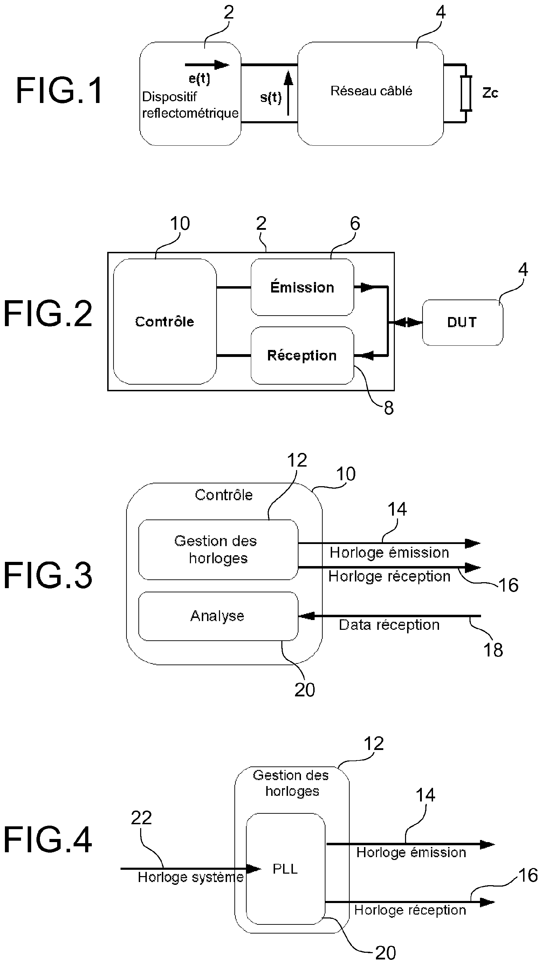

La figure 1 représente un dispositif 2 de détection et de localisation de défauts par réflectométrie, connecté à l'entrée d'un réseau électrique câblé 4 ayant une impédance caractéristique Zc, tel que par exemple un réseau de transports d'énergie, un réseau électrique de contrôle de processus industriel, un réseau câblé de communication, ou encore un réseau électrique câblé embarqué équipant un véhicule mobile (avion, train voiture...) .

Comme on peut le voir à la figure 2, le dispositif 2, comporte un module d'émission 6 destiné à injecter des signaux de test dans le réseau 4, un module de réception 8 destiné à récupérer un signal réfléchi pour chaque signal de test injecté comportant des moyens pour échantillonner chaque signal réfléchi à une fréquence Fe=1/Te, un module de contrôle 10 destiné à analyser les échantillons des signaux réfléchis.

Comme on peut le voir à la figure 3, le module de contrôle 10 comporte un module de synchronisation 12 destiné à générer un signal d'horloge d'émission 14 et un signal d'horloge de réception 16 et un module d'analyse recevant les signaux réfléchis 18.

Dans un mode préféré de réalisation illustré schématiquement par la figure 4, le module de synchronisation 12 est constitué par un circuit PLL 20 qui génère de façon connue en soi le signal d'horloge d'émission 14 et le signal d'horloge de réception 16 à partir du signal d'horloge de fonctionnement 22 du dispositif de détection de défauts.

En fonctionnement, le module d'émission 2 injecte un signal de test dans le réseau électrique 4, N fois successives, N étant un nombre entier, les injections successives étant désynchronisées d'une durée $\delta$ très courte devant Te (pouvant être de l'ordre de quelques centaines de picosecondes ou moins). Chaque signal réfléchi par le réseau électrique 4 est échantillonné à une fréquence Fe=1/Te, Te étant la période d'échantillonnage, de manière à récupérer, pour chaque signal réfléchi, n échantillons, n étant un nombre entier.

Soit s(t) le signal réfléchit, $S_e(k)$ le signal échantillonné et $T_e$ la période d'échantillonnage. On a alors :

$$S_e(k) = \sum_{k=0}^{\infty} s(k * T_e)$$

L'invention tire avantage du fait que si l'on réinjecte le signal de test e(t) dans le réseau électrique, alors le signal réfléchi $s_2(t)$ correspondant au deuxième signal de test injecté est tel que $s_2(t)=s(t)$ (hypothèse de stationnarité du réseau).

Si on introduit un décalage temporel $\delta_2 < T_e$ entre l'injection du signal e(t) et l'échantillonnage du signal réfléchi $s_2(t)$ correspondant alors on a :

$$s_{e2}(k) = \sum_{k=0}^{\infty} s_2(k * T_e)$$

$$= \sum_{k=0}^{\infty} s(k * T_e + \delta_2)$$

Si on reproduit N fois cette opération en prenant $\delta_i = i * \dfrac{T_e}{N}$, $\forall i \in [0; n-1]$ on obtient :

$$\sum_{i=0}^{N-1} s_{ei}(k) = \sum_{k=0}^{\infty} s_0(k * T_e) + s_1(k * T_e) + \ldots + s_{N-1}(k * T_e)$$

$$= \sum_{k=0}^{\infty} s(k * T_e + \delta_0) + s(k * T_e + \delta_1) + \ldots + s(k * T_e + \delta_{N-1})$$

$$= \sum_{k=0}^{\infty} s(k * T_e + 0 * \dfrac{T_e}{N}) + s(k * T_e + 1 * \dfrac{T_e}{N}) + \ldots + s(k * T_e + (N-1) * \dfrac{T_e}{N})$$

$$= \sum_{k=0}^{\infty} s(k * \dfrac{T_e}{N})$$

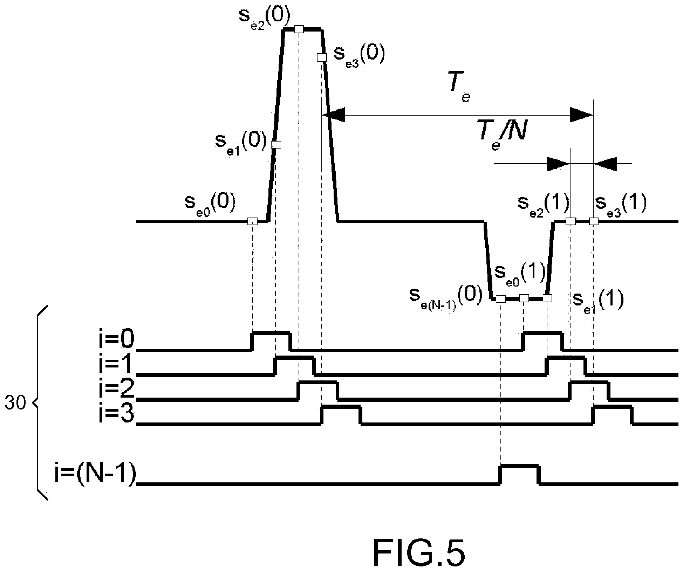

Ainsi, comme cela est illustré par la figure 5, en combinant les échantillons de chaque signal réfléchi, on obtient une pseudo-période d'échantillonnage de Te/N tout en conservant une période d'échantillonnage Te pour chaque signal réfléchi récupéré.

Sur cette figure 5, le signal test est un signal rectangulaire injecté N fois successives sur un câble du réseau électrique 4. Le signal réfléchi s(t) est échantillonné à une fréquence Fe=1/Te de manière à récupérer n échantillons $s_{ei}(k)$, i= 0 à n-1. Le signal d'horloge d'émission 14 est représenté par les N créneaux 30. Les n*N échantillons $s_{ei}(k)$ sont soit combinés pour reconstituer un signal réfléchi sur-échantillonné reflétant la courbe de diagnostic représentant le câble du réseau avec plus de précision, soit analysés individuellement avant la reconstitution du signal réfléchi de manière à obtenir une représentation de ladite courbe de diagnostic par une analyse statistique des échantillons successifs.

Ainsi, pour chaque signal test, le module de réception 8 récupère n*N échantillons à partir de convertisseurs fonctionnant à quelques centaines de MHz voire quelques MHz ou même quelques Hz. La précision des mesures ne dépend plus des convertisseurs.

Plus généralement, le module de synchronisation 12 contrôle le signal d'horloge de l'émission 14 et la fréquence d'échantillonnage des signaux réfléchis 16 de sorte que les N injections successives du signal de test ne soient pas synchrones avec la période d'échantillonnage Te.

Avantageusement, lorsque le signal test est rectangulaire, le module de contrôle 10 contrôle la largeur de ce signal de manière à réduire l'affaiblissement du signal réfléchi. Ceci permet de tenir compte des caractéristiques physiques des câbles électriques testés.

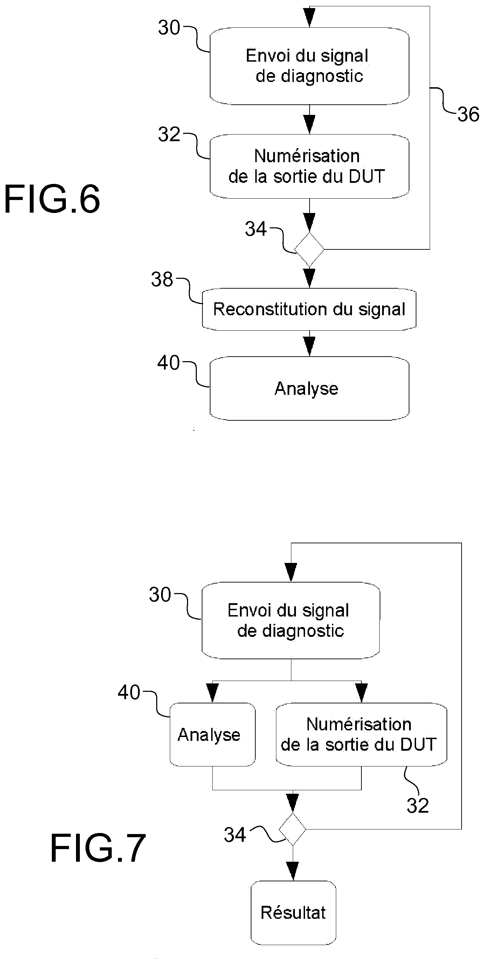

Dans un premier mode de réalisation illustré par la figure 6, le procédé comporte les étapes suivantes :

- injecter (étape 30) un signal de test e(t) dans un câble du réseau électrique 4,
- échantillonner (étape 32) le signal réfléchi à une fréquence Fe=1/Te,
- compter le nombre d'échantillons obtenus pour le signal réfléchi et comparer (étape 34) le nombre d'échantillons obtenus à un nombre n prédéfini en fonction de la longueur du câble ou du réseau à diagnostiquer,
- répéter (flèche 36) N fois les étapes 30, 32 et 34 en décalant l'horloge d'émission 14 d'une durée $\delta$,
- reconstituer (étape 38) le signal réfléchi à partir des n*N échantillons obtenus,
- analyser (étape 40) le signal réfléchi pour détecter un défaut.

Notons que l'étape d'analyse 40 peut être réalisée au moyen d'un algorithme de traitement de signal sans sortir du cadre de l'invention.

Dans ce mode de réalisation, les M=n*N échantillons obtenus sont d'abord mémorisés, puis utilisés pour reconstituer le signal réfléchi qui sera ensuite analysé en différé.

La figure 7 illustre un deuxième mode de réalisation dans lequel l'étape d'analyse 40 est réalisée parallèlement à l'étape d'échantillonnage 32. Dans ce cas le signal n'est pas reconstitué, afin d'obtenir rapidement le résultat de la localisation du défaut.

Dans l'exemple de réalisation du module de synchronisation illustré par la figure 4 le circuit PLL utilisé est disponible dans un FPGA et permet de générer un décalage temporel minimal entre le signal d'émission et le signal d'horloge de réception dont la valeur est donnée par l'expression

$$\delta_{min} = \frac{1}{8 \cdot f_{vco}}$$

où $f_{vco}$ représente la fréquence du VCO (pour Voltage Controlled Oscillator). Cette fréquence peut atteindre 1000 MHz pour une fréquence d'entrée de 100 MHz. Il en résulte un décalage temporel minimal $\delta_{min}$ = 125ps, ce qui équivaut à une fréquence de sur-échantillonnage de 8 GHz.

Cependant, la désynchronisation peut être réalisée à partir de n'importe quel système permettant de contrôler un décalage temporel entre deux signaux, tel que par exemple un circuit DLL pour (Delay Locked Loop) ou tout autre circuit sans sortir du cadre de l'invention.

Notons que le procédé peut être réalisé en fixant le signal de l'horloge de réception et en décalant le signal de l'horloge d'émission par rapport au signal d'échantillonnage ou en fixant le signal de l'horloge d'émission et en décalant le signal de l'horloge de réception ou même en décalant les signaux des deux horloges par rapport au signal d'échantillonnage sans sortir du cadre de l'invention.

Notons également que pour détecter les pics résultant de l'échantillonnage, le dispositif et le procédé, traitant le signal échantillonné, utilisent un seuil adaptatif qui est recalculé pour chaque diagnostic en fonction des signaux d'entrée.

**Revendications**

1. Procédé de détection et de localisation de défauts par réflectométrie dans un réseau électrique câblé (4) comportant une phase d'acquisition comprenant les étapes suivantes :

    - injecter (30) un signal de test dans un câble dudit réseau,
    - récupérer un signal réfléchi sur ledit câble,

- échantillonner ledit signal réfléchi à une fréquence Fe=1/Te, Te étant une période d'échantillonnage, de manière à récupérer, pour chaque signal réfléchi, n échantillons, n étant un nombre entier,
- renouveler N fois les étapes précédentes de la phase d'acquisition, N étant un nombre entier,

les injections successives de signaux de test étant désynchronisées par rapport au début de ladite phase d'acquisition d'une durée incrémentée d'une valeur δ1 très courte devant Te,

- reconstituer (38) un signal réfléchi à partir desdits échantillons,
- analyser (40) les M=n*N échantillons récupérés pour détecter et localiser un défaut dans le réseau électrique câblé à partir de l'analyse du signal ainsi reconstitué,

procédé **caractérisé en ce que** le premier échantillon du signal réfléchi est récupéré de manière désynchronisée par rapport au début de ladite phase d'acquisition d'une durée incrémentée d'une valeur δ2 et les échantillons suivants dudit signal réfléchi étant récupérés avec un retard constant, multiple de la période d'échantillonnage Te, par rapport audit premier échantillon.

2. Procédé de détection et de localisation de défauts par réflectométrie dans un réseau électrique câblé (4) comportant une phase d'acquisition comprenant les étapes suivantes :

- injecter (30) un signal de test dans un câble dudit réseau,
- récupérer un signal réfléchi sur ledit câble,
- échantillonner ledit signal réfléchi à une fréquence Fe=1/Te, Te étant une période d'échantillonnage, de manière à récupérer, pour chaque signal réfléchi, n échantillons, n étant un nombre entier
- renouveler N fois les étapes précédentes de la phase d'acquisition, N étant un nombre entier,

les injections successives de signaux de test étant désynchronisées par rapport au début de ladite phase d'acquisition d'une durée d'une valeur 61 très courte devant Te,

- analyser (40) les M=n*N échantillons récupérés pour détecter et localiser un défaut dans le réseau électrique câblé à partir de l'analyse du signal ainsi reconstitué,

procédé **caractérisé en ce que** l'étape d'analyse (40) est réalisée parallèlement à l'étape d'échantillonnage (32) et **en ce que** le premier échantillon du signal réfléchi est récupéré de manière désynchronisée par rapport au début de ladite phase d'acquisition d'une durée incrémentée d'une valeur δ2 et les échantillons suivants dudit signal réfléchi étant récupérés avec un retard constant, multiple de la période d'échantillonnage Te, par rapport audit premier échantillon.

3. Procédé selon la revendication 2, dans lequel la détection et la localisation d'un défaut dans le réseau électrique câblé sont effectuées par analyse en temps réel de chaque échantillon récupéré et par traitement des résultats des analyses successives.

4. Procédé selon la revendication 1 ou la revendication 2 dans lequel le nombre N est choisi en fonction de la précision de détection et de localisation souhaitée.

5. Procédé selon la revendication 1 ou la revendication 2, dans lequel le signal test est un signal rectangulaire.

6. Procédé selon la revendication 5, comportant en outre une étape consistant à contrôler la durée dudit signal rectangulaire.

7. Procédé selon la revendication 1 ou la revendication 2, dans lequel ledit signal test est composé d'une suite de signaux rectangulaires.

8. Procédé selon l'une des revendications 1 à 7 dans lequel la localisation du défaut sur un câble est déterminée en fonction de la durée séparant l'instant d'émission du signal test injecté dans ledit câble et l'instant d'arrivée du signal réfléchi correspondant audit défaut sur ledit câble.

9. Dispositif de détection et de localisation de défauts par réflectométrie dans un réseau électrique câblé comportant :

- un module d'émission (2) configuré pour injecter un signal de test dans un câble dudit réseau un nombre N de fois, N étant un nombre entier,
- un module de réception (8) configuré pour récupérer un signal réfléchi pour chaque signal de test injecté, ledit module de réception (8) comportant des moyens pour échantillonner chaque signal réfléchi à une fréquence Fe=1/Te, Te étant une période d'échantillonnage,
- une horloge globale (22),
- un module de contrôle (10) comprenant un module de synchronisation (12) configuré pour générer un signal d'horloge d'émission (14) et configuré pour déterminer les instants auxquels les injections successives d'un signal de test dans un câble dudit réseau sont faites, une horloge de réception (16), ledit module de contrôle (10) étant configuré pour analyser les M=n*N échantillons obtenus et comportant des moyens pour synchroniser et désynchroniser le module d'émission et le module de réception, et des moyens pour :
- reconstituer un signal réfléchi à partir desdits échantillons,
- détecter et localiser un défaut dans le réseau électrique câblé à partir de l'analyse du signal ainsi reconstitué,

les injections successives d'un signal de test dans un câble dudit réseau sont désynchronisées par rapport à ladite horloge globale d'une durée incrémentée d'une valeur $\delta 1$,
dispositif **caractérisé en ce que** l'horloge de réception est configurée de sorte que pour chaque signal injecté, le premier échantillon du signal réfléchi soit récupéré de manière désynchronisée par rapport à ladite horloge globale, d'une durée incrémentée d'une valeur $\delta 2$, les échantillons suivants dudit signal réfléchi étant récupérés avec un retard constant, multiple de la période d'échantillonnage Te, par rapport audit premier échantillon.

**10.** Dispositif selon la revendication 9, dans lequel ledit module de synchronisation (12) est un circuit PLL ou un circuit DLL.

**Patentansprüche**

**1.** Verfahren zum Erkennen und Lokalisieren von Fehlern durch Reflektometrie in einem verdrahteten elektrischen Netzwerk (4), das eine Erfassungsphase umfasst, die die folgenden Schritte umfasst:

- Einleiten (30) eines Testsignals in ein Kabel des Netzwerks,
- Abgreifen eines an dem Kabel reflektierten Signals,
- Abtasten des reflektierten Signals mit einer Frequenz Fe = 1/Te, wobei Te eine Abtastperiode ist, um für jedes reflektierte Signal n Abtastwerte abzugreifen, wobei n eine ganze Zahl ist,
- N-maliges Wiederholen der vorherigen Schritte der Erfassungsphase, wobei N eine ganze Zahl ist,

wobei die aufeinanderfolgenden Einleitungen von Testsignalen in Bezug auf den Beginn der Erfassungsphase um eine Dauer desynchronisiert werden, die um einen Wert $\delta 1$ erhöht ist, der sehr kurz vor Te liegt,

- Rekonstruieren (38) eines reflektierten Signals ausgehend von den Abtastwerten,
- Analysieren (40) der M = n*N abgegriffenen Abtastwerte, um einen Fehler im verdrahteten elektrischen Netzwerk basierend auf der Analyse des so rekonstruierten Signals zu erkennen und zu lokalisieren,

wobei das Verfahren **dadurch gekennzeichnet ist, dass**
der erste Abtastwert des reflektierten Signals in Bezug auf den Beginn der Erfassungsphase um eine Zeitdauer desynchronisiert abgegriffen wird, die um einen Wert $\delta 2$ erhöht ist, und die nachfolgenden Abtastwerte des reflektierten Signals mit einer konstanten Verzögerung, die ein Vielfaches der Abtastperiode Te beträgt, in Bezug auf den ersten Abtastwert abgegriffen werden.

**2.** Verfahren zum Erkennen und Lokalisieren von Fehlern durch Reflektometrie in einem verdrahteten elektrischen Netzwerk (4), das eine Erfassungsphase umfasst, die die folgenden Schritte umfasst:

- Einleiten (30) eines Testsignals in ein Kabel des Netzwerks,
- Abgreifen eines an dem Kabel reflektierten Signals,
- Abtasten des reflektierten Signals mit einer Frequenz Fe = 1/Te, wobei Te eine Abtastperiode ist, um für jedes reflektierte Signal n Abtastwerte abzugreifen, wobei n eine ganze Zahl ist,
- N-maliges Wiederholen der vorherigen Schritte der Erfassungsphase, wobei N eine ganze Zahl ist,

wobei die aufeinanderfolgenden Einleitungen von Testsignalen in Bezug auf den Beginn der Erfassungsphase um eine Zeitdauer mit einem Wert $\delta1$ desynchronisiert werden, der sehr kurz vor Te liegt,

- Analysieren (40) der M = n*N abgegriffenen Abtastwerte, um einen Fehler im verdrahteten elektrischen Netzwerk basierend auf der Analyse des so rekonstruierten Signals zu erkennen und zu lokalisieren,

wobei das Verfahren **dadurch gekennzeichnet ist, dass**
der Schritt des Analysierens (40) parallel zum Schritt des Abtastens (32) erfolgt und dass der erste Abtastwert des reflektierten Signals in Bezug auf den Beginn der Erfassungsphase um eine Zeitdauer desynchronisiert abgegriffen wird, die um einen Wert $\delta2$ erhöht ist, und die nachfolgenden Abtastwerte des reflektierten Signals mit einer konstanten Verzögerung, die ein Vielfaches der Abtastperiode Te beträgt, in Bezug auf den ersten Abtastwert abgegriffen werden.

3. Verfahren nach Anspruch 2,
   wobei das Erkennen und Lokalisieren eines Fehlers in dem verdrahteten elektrischen Netzwerk durch Analyse jedes abgegriffenen Abtastwerts in Echtzeit und durch Verarbeiten der Ergebnisse der aufeinanderfolgenden Analysen erfolgen.

4. Verfahren nach Anspruch 1 oder Anspruch 2,
   wobei die Anzahl N in Abhängigkeit von der gewünschten Genauigkeit des Erkennens und Lokalisierens ausgewählt wird.

5. Verfahren nach Anspruch 1 oder Anspruch 2,
   wobei das Testsignal ein Rechtecksignal ist.

6. Verfahren nach Anspruch 5,
   ferner umfassend einen Schritt, der darin besteht, die Zeitdauer des Rechtecksignals zu überprüfen.

7. Verfahren nach Anspruch 1 oder Anspruch 2,
   wobei das Testsignal aus einer Folge von Rechtecksignalen besteht.

8. Verfahren nach einem der Ansprüche 1 bis 7,
   wobei das Lokalisieren des Fehlers an einem Kabel in Abhängigkeit von der Zeitdauer bestimmt wird, welche den Sendezeitpunkt des in das Kabel eingeleiteten Testsignals von dem Empfangszeitpunkt des reflektierten Signals trennt, der dem Fehler am Kabel entspricht.

9. Vorrichtung zum Erkennen und Lokalisieren von Fehlern durch Reflektometrie in einem verdrahteten elektrischen Netzwerk, enthaltend:

   - ein Sendemodul (2), das dazu ausgelegt ist, N-mal ein Testsignal in ein Kabel des Netzwerks einzuleiten, wobei N eine ganze Zahl ist,
   - ein Empfangsmodul (8), das dazu ausgelegt ist, ein reflektiertes Signal für jedes eingeleitete Testsignal abzugreifen, wobei das Empfangsmodul (8) Mittel zum Abtasten jedes reflektierten Signals mit einer Frequenz Fe = 1/Te enthält, wobei Te eine Abtastperiode ist,
   - einen globalen Taktgeber (22),
   - ein Steuermodul (10), das ein Synchronisationsmodul (12) enthält, das dazu ausgelegt ist, ein Sendetaktsignal (14) zu erzeugen, und dazu ausgelegt ist, die Zeitpunkte zu bestimmen, an denen die aufeinanderfolgenden Einleitungen eines Testsignals in ein Kabel des Netzwerks erfolgt sind, einen Empfangstaktgeber (16), wobei das Steuermodul (10) dazu ausgelegt ist, die M = n*N erhaltenen Abtastwerte zu analysieren, und Mittel zum Synchronisieren und Desynchronisieren des Sendemoduls und des Empfangsmoduls enthält, sowie Mittel zum:
   - Rekonstruieren eines reflektierten Signals ausgehend von den Abtastwerten,
   - Erkennen und Lokalisieren eines Fehlers in dem verdrahteten elektrischen Netzwerk ausgehend von der Analyse des so rekonstruierten Signals,

   wobei die aufeinanderfolgenden Einleitungen eines Testsignals in ein Kabel des Netzwerks in Bezug auf den globalen Taktgeber um eine Zeitdauer desynchronisiert sind, die um einen Wert $\delta1$ erhöht ist,
   wobei die Vorrichtung **dadurch gekennzeichnet ist, dass**
   der Empfangstaktgeber so ausgelegt ist, dass bei jedem eingeleiteten Signal der erste Abtastwert des reflektierten Signals in Bezug auf den globalen Taktgeber um eine Zeitdauer desynchronisiert abgegriffen wird, die um einen Wert $\delta 2$ erhöht ist, wobei die nachfolgenden Abtastwerte des reflektierten Signals mit einer konstanten Verzögerung, die ein Vielfaches der Abtastperiode Te beträgt, in Bezug auf den ersten Abtastwert abgegriffen werden.

**10.** Vorrichtung nach Anspruch 9,
wobei das Synchronisationsmodul (12) eine PLL-Schaltung oder eine DLL-Schaltung ist.

**Claims**

**1.** Method for detecting and locating faults by reflectometry in a wired electrical network (4) comprising an acquisition phase comprising the following steps:

- inject (30) a test signal into a cable of said network,
- retrieve a reflected signal on said cable,
- sample said reflected signal at a frequency Fe=1/Te, Te being a sampling period, so as to retrieve n samples for each reflected signal, n being an integer number,
- repeat N times the previous steps of the acquisition phase, N being an integer number,

the successive injections of test signals being desynchronised from the beginning of said acquisition phase by a duration incremented by a value $\delta 1$ very short compared with Te,

- reconstitute (38) a reflected signal from said samples,
- analyse (40) the M=n*N retrieved samples for detecting and locating a fault in the wired electrical network from the analysis of the signal thus reconstituted,

method **characterized in that** the first sample of the reflected signal is retrieved in a desynchronised manner with regard to the beginning of said acquisition phase by a duration incremented by a value $\delta 2$ and the following samples of said reflected signal being retrieved with a constant delay, that is a multiple of the sampling period Te, relative to said first sample.

**2.** Method for detecting and locating faults by reflectometry in a wired electrical network (4) comprising an acquisition phase comprising the following steps:

- inject (30) a test signal into a cable of said network,
- retrieve a reflected signal on said cable,
- sample said reflected signal at a frequency Fe=1/Te, Te being a sampling period, so as to retrieve n samples for each reflected signal, n being an integer number,
- repeat N times the previous steps of the acquisition phase, N being an integer number,

the successive injections of test signals being desynchronised from the beginning of said acquisition phase by a duration incremented by a value $\delta 1$ very short compared with Te

- analyse (40) the M=n*N retrieved samples for detecting and locating a fault in the wired electrical network from the analysis of the signal thus reconstituted,

method **characterized in that** the analysing step (40) is performed in parallel to the sampling step (32) and **in that** the first sample of the reflected signal is retrieved in a desynchronised manner with regard to the beginning of said acquisition phase by a duration incremented by a value $\delta 2$ and the following samples of said reflected signal being retrieved with a constant delay, that is a multiple of the sampling period Te, relative to said first sample.

**3.** Method according to claim 2, in which the detection and locating a fault in the wired electrical network are done by analysis of each retrieved sample in real time and by processing the results of the successive analyses.

**4.** Method according to claim 1 or claim 2, in which the number N is chosen as a function of the required fault detection and locating precision.

**5.** Method according to claim 1 or claim 2, in which the test signal is a rectangular signal.

**6.** Method according to claim 5, further comprising a step consisting of testing the duration of said rectangular signal.

**7.** Method according to claim 1 or claim 2, in which said test signal is composed of a sequence of rectangular signals.

**8.** Method according to one of claims 1 to 7, in which the locating of a fault on a cable is determined as a function of the duration between the instant at which the test signal injected into said cable is sent and the instant at which the reflected signal corresponding to said fault on said cable arrives.

**9.** Device for fault detection and locating by reflectometry in a wired electrical network comprising:

- an emission module (2) configured to inject a test signal into a cable of said network a number N of times, N being an integer number,
- a reception module (8) configured to retrieve a reflected signal for each injected test signal, said reception module (8) comprising means of sampling each reflected signal at a frequency $Fe=1/Te$, Te being a sampling period,
- a global clock (22),
- a test module (10) comprising a synchronisation module (12) configured to generate an emission clock signal 14 and configured to determine the instants at which the successive injections of a test signal into a cable of said network are made, a reception clock (16), said test module (10) being configured to analyse the $M=n*N$ samples obtained and comprising means for synchronising and desynchronising the emission module and the reception module, and means for:
- reconstituting a reflected signal from said samples,
- detecting and locating a fault in the wired electrical network from the analysis of the signal thus reconstituted,

the successive injections of a test signal into a cable of said network are desynchronised from the global clock by a duration incremented by a value $\delta 1$,
device **characterized in that** the reception clock is configured such that for each injected signal, the first sample of the reflected signal is retrieved desynchronized compared to said global clock, by a duration incremented by a value $\delta 2$, the following samples of the reflected signal being retrieved with a constant delay, that is a multiple of Te, relative to the first sample.

**10.** Device according to claim 9, in which said synchronisation module (12) is a PLL circuit or a DLL circuit.

FIG.1

FIG.2

FIG.3

FIG.4

FIG.5

FIG.6

30 — Envoi du signal de diagnostic

36

32 — Numérisation de la sortie du DUT

34 —

38 — Reconstitution du signal

40 — Analyse

FIG.7

30 — Envoi du signal de diagnostic

40 — Analyse

Numérisation de la sortie du DUT — 32

34 — 

Résultat